# EUROPEAN PATENT APPLICATION

(11) **EP 2 978 027 A1**
(43) Date of publication of application: **27.01.2016**
(21) Application number: 14769293.3
(22) Date of filing: 18.03.2014
(51) Int. Cl.: H01L 31/0747

(54) **PHOTOVOLTAIC ELEMENT AND MANUFACTURING METHOD THEREFOR**

(30) Priority: 19.03.2013 JP 2013056748
(71) Applicant: Choshu Industry Co., Ltd., Sanyo-onoda-shi, Yamaguchi 757-8511 (JP)
(72) Inventor: KOBAYASHI Eiji, Sanyo-onoda-shi Yamaguchi 757-8511 (JP)
(74) Representative: von Kreisler Selting Werner - Partnerschaft von Patentanwälten und Rechtsanwälten mbB
(86) International application number: PCT/JP2014/057366
(87) International publication number: WO 2014/148499

(57) **Abstract**

Provided are a photo-electric power generating element having a sufficient fill factor, and enabling a manufacturing cost to be reduced, and a manufacturing method therefor. A photo-electric power generating element 10 including: an n-type crystal semiconductor substrate 11; a p-type amorphous silicon thin film 13 overlaid on one face side of the n-type crystal semiconductor substrate 11; and an n-type amorphous silicon thin film 15 overlaid on another face side of the n-type crystal semiconductor substrate 11, in which the photo-electric power generating element 10 further includes an intrinsic amorphous silicon thin film 12 interposed between the n-type crystal semiconductor substrate 11 and the p-type amorphous silicon thin film 13, the n-type crystal semiconductor substrate 11 and the n-type amorphous silicon thin film 15 are directly bonded, and a side on which the n-type amorphous silicon thin film 15 is provided is used as a plane of light incidence.

## Description

### [Technical Field]

The present invention relates to a photo-electric power generating element (solar cell) having heterojunctions, and a manufacturing method therefor.

### [Background Art]

As a clean electric power generation means not accompanied by generation of greenhouse gas such as CO₂, and as an electric power generation means that may replace nuclear electric power generation and that is highly operationally safe, photo-electric power generating elements (solar cells) have attracted attention. One of the photo-electric power generating elements is a photo-electric power generating element having heterojunctions that exhibits superior efficiency of electric power generation.

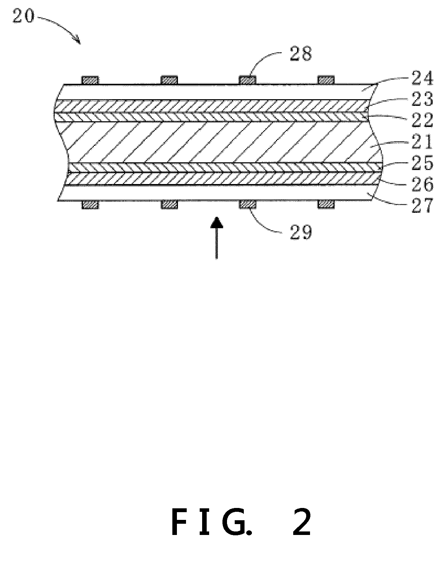

As shown in FIG. 2, the photo-electric power generating element 20 having heterojunctions includes: a first intrinsic amorphous silicon thin film 22, a p-type amorphous silicon thin film 23 and a first transparent conductive film 24 overlaid in this order on one side of an n-type crystal semiconductor substrate 21, whereas a second intrinsic amorphous silicon thin film 25, an n-type amorphous silicon thin film 26 and a second transparent conductive film 27 overlaid in this order on other side of the n-type crystal semiconductor substrate 21. Furthermore, collector electrodes 28, 29 are provided on the surface of the first transparent conductive film 24 and the second transparent conductive film 27, respectively. It is to be noted that the arrowhead in FIG. 2 indicates the incident direction of light, and thus the other side serves as a plane of light incidence. When a structure in which the n-type crystal semiconductor substrate 21 is directly bonded to the n-type amorphous silicon thin film 26 is provided as a BSF structure, the interfacial level increases due to mismatching of crystal structures and/or doping, and recombination of photoproduction carriers increases; however, by allowing the second intrinsic amorphous silicon thin film 25 to be interposed as in the photo-electric power generating element 20, recombination of the photoproduction carriers is reportedly inhibited, and thus the efficiency of electric power generation may be enhanced (see Patent Document 1).

### [Prior Art Documents]

### [Patent Documents]

Patent Document 1: Japanese Patent No. 2614561

### [Nonpatent Documents]

Nonpatent Document 1: W. E. Spear and P. G. LeComber: Solid State Commun. 17 (1975) 1193

### [SUMMARY OF THE INVENTION]

### [Problems to be Solved by the Invention]

Each silicon thin film constructing the photo-electric power generating element having the structure described above is typically formed by a plasma CVD process. In this procedure, when an intrinsic amorphous silicon thin film is interposed between the n-type crystal semiconductor substrate and the n-type amorphous silicon thin film, in order to prevent the intrinsic amorphous silicon thin film from contamination with electric conductivity-determining impurities, it is necessary to (1) carry out film formation of the n-type amorphous silicon thin film and the intrinsic amorphous silicon thin film in distinct film forming rooms, (2) carry out the film formation in a state in which the wall surface of the film forming room is covered, and/or the like. However, in the case of the case (1) above, since a plurality of film forming rooms are required, initial costs for introducing the manufacturing apparatus increases, whereas in the case of the case (2) above, running costs in manufacturing may increase.

The present invention was made in view of such circumstances, and it is an object of the present invention to provide: a photo-electric power generating element having a sufficient open circuit voltage and fill factor, and enabling a manufacturing cost to be reduced; and a manufacturing method therefor.

### [Means for Solving the Problems]

The photo-electric power generating element according to the first aspect of the present invention that attains the aforementioned object includes:
an n-type crystal semiconductor substrate; a p-type amorphous silicon thin film overlaid on one face side of the n-type crystal semiconductor substrate; and an n-type amorphous silicon thin film overlaid on another face side of the n-type crystal semiconductor substrate,
in which
the photo-electric power generating element further includes an intrinsic amorphous silicon thin film interposed between the n-type crystal semiconductor substrate and the p-type amorphous silicon thin film,
the n-type crystal semiconductor substrate and the n-type amorphous silicon thin film are directly bonded, and
a side on which the n-type amorphous silicon thin film is provided is used as a plane of light incidence.

Since an intrinsic amorphous silicon thin film is not interposed between the n-type crystal semiconductor substrate and the n-type amorphous silicon thin film in the photo-electric power generating element according to the first aspect of the present invention, the manufacturing cost can be reduced. In addition, without interposing the intrinsic amorphous silicon thin film between the n-type crystal semiconductor substrate and the n-type amorphous silicon thin film in this manner, the photo-electric power generating element according to the first aspect of the present invention can have a sufficient open circuit voltage and fill factor through the use of the side on which the n-type amorphous silicon thin film is provided (another face side) as a plane of light incidence.

In the photo-electric power generating element according to the first aspect of the present invention, it is preferred that the n-type amorphous silicon thin film is overlaid by a chemical vapor deposition process that includes at least two steps in which a content of a dopant gas in the source gas increases in sequence. Accordingly, improved passivation properties of the bonded interface between the n-type crystal semiconductor substrate and the n-type amorphous silicon thin film, and the like enable the open circuit voltage and the fill factor to be further increased. It is to be noted that the phrase "at least two steps in which a content of a dopant gas in the source gas increases in sequence" as referred to involves also cases in which the content continuously increases.

In the photo-electric power generating element according to the first aspect of the present invention, it is preferred that the n-type amorphous silicon thin film includes a first layer that directly bonds to the n-type crystal semiconductor substrate, and a second layer that is overlaid on the another face side of the first layer and has an electric resistance less than that of the first layer. Also in this case, improved passivation properties of the bonded interface between the n-type crystal semiconductor substrate and the n-type amorphous silicon thin film, and the like, similarly to the case described above, enable the open circuit voltage and the fill factor to be further increased.

In the photo-electric power generating element according to the first aspect of the present invention, it is preferred that the n-type amorphous silicon thin film is overlaid by a chemical vapor deposition process, overlaying by the chemical vapor deposition process is carried out in a state in which a temperature of the n-type crystal semiconductor substrate is greater than 180 °C and no less than 220 °C. By thus carrying out the overlaying of the n-type amorphous silicon thin film by the chemical vapor deposition process in the state in which the temperature of the n-type crystal semiconductor substrate falls within a comparatively high temperature range described above, the n-type amorphous silicon thin film accompanied by prevented generation of defects can be obtained while crystallization is inhibited.

In the photo-electric power generating element according to the first aspect of the present invention, the n-type crystal semiconductor substrate is preferably produced by an epitaxy process. When the n-type crystal semiconductor substrate produced by an epitaxy process is used, output characteristics such as maximum output of the photo-electric power generating element, and uniformity thereof can be improved.

In the photo-electric power generating element according to the first aspect of the present invention, it is preferred that the resistivity of the n-type crystal semiconductor substrate is no less than 0.5 Ωcm and no greater than 5 Ωcm. When the n-type crystal semiconductor substrate having a resistivity falling within the above range is used, maximum output and the like can be increased.

In the photo-electric power generating element according to the first aspect of the present invention, a thickness of the n-type crystal semiconductor substrate is preferably no less than 50 µm and no greater than 200 µm, and more preferably no less than 80 µm and no greater than 150 µm. When the substrate thus has a comparatively small thickness, miniaturization of the element itself, and cost reduction can be achieved while sufficient output characteristics are achieved.

The method for manufacturing a photo-electric power generating element according to the second aspect of the present invention that attains the aforementioned object includes the step of overlaying an n-type amorphous silicon thin film on a surface of an n-type crystal semiconductor substrate by a chemical vapor deposition process,
in which overlaying by the chemical vapor deposition process is carried out in a state in which a temperature of the n-type crystal semiconductor substrate is greater than 180 °C and no less than 220 °C.

According to the method for manufacturing a photo-electric power generating element of the second aspect of the present invention, the n-type amorphous silicon thin film is directly overlaid on the surface of the n-type crystal semiconductor substrate by a chemical vapor deposition process without an intrinsic amorphous silicon thin film interposed, and therefore, the manufacturing cost can be reduced. In addition, by carrying out the overlaying of the n-type amorphous silicon thin film in a state in which a temperature of the n-type crystal semiconductor substrate falls within a comparatively high temperature range described above, the n-type amorphous silicon thin film accompanied by prevented generation of defects can be obtained while crystallization is inhibited, and a photo-electric power generating element having a sufficient open circuit voltage and fill factor can be obtained.

The term "intrinsic" in the "intrinsic amorphous silicon thin film" as referred to herein means that an impurity is not intentionally doped, and involves the state in which impurities originally contained in the basic material, and/or impurities unintentionally incorporated in the manufacturing step are present. Further, the term "amorphous" as referred to means not only amorphous but also microcrystalline inclusively. The term "plane of light incidence" as referred to means a face that is positioned on the side opposing to a light source such as sunlight in use (in general, external side), and thus that is on the side at which the light enters substantially, but a construction such that the light enters also from the reverse face to the plane of light incidence is also acceptable.

On the other hand, "'n-type' amorphous silicon thin film" as referred to herein includes the "n-type" dopant in an amount of no less than about 10⁻⁵ with respect to the silicon in terms of a ratio of number density of elements contained in the thin film. For example, according to Nonpatent Document 1, amorphous silicon not intentionally doped is found to be slightly n-type. The "'intrinsic' amorphous silicon" as referred to in Patent Document 1 is speculated to include those having characteristics of n-type despite the absence of such intentional doping. To the contrary, in the present invention, the definition has been made in connection with the ratio of number density of dopants as described above, and therefore, the term "'n-type' amorphous silicon thin film" involves only intentionally doped one. It is to be noted that, for example, in Nonpatent Document 1, it is shown that when the value "PH₃/SIH₄" is greater than 10⁻⁵, characteristics distinct from those of intentionally undoped amorphous silicon were attained.

### [Effects of the Invention]

The photo-electric power generating element according to an aspect of present invention has a sufficient fill factor, and enables the manufacturing cost to be reduced. In addition, according to the method for manufacturing a photo-electric power generating element of other aspect of the present invention, a photo-electric power generating element having a sufficient open circuit voltage and fill factor can be obtained with a reduced manufacturing cost.

### [BRIEF DESCRIPTION OF THE DRAWINGS]

FIG. 1 shows a cross sectional view illustrating a photo-electric power generating element according to a first embodiment of the present invention;
FIG. 2 shows a cross sectional view illustrating a photo-electric power generating element according to a conventional example;
FIG. 3 shows a schematic view illustrating a method for measuring the film thickness of an amorphous silicon thin film in Examples; and
FIG. 4 (a) shows a graph indicating the results of measurements of FF (fill factor) of each photo-electric power generating element of Example 3, and FIG. 4 (b) shows a graph indicating the results of measurements of Pmax (maximum output) of each photo-electric power generating element of Example 3.

### [Description of Embodiments]

In the following, embodiments for carrying out the present invention will be explained with reference to the attached drawings.

### Photo-Electric Power Generating Element

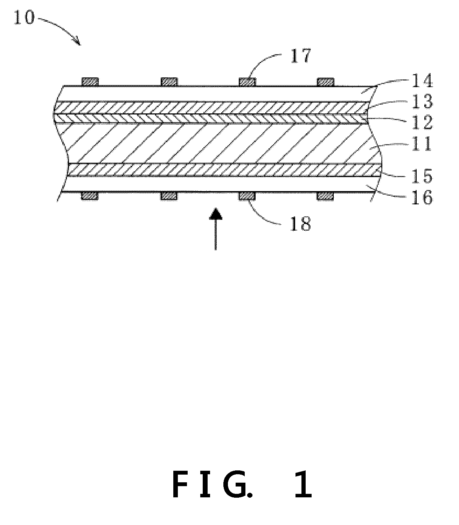

As shown in FIG. 1, a photo-electric power generating element 10 according to the first embodiment of the present invention has a platy multilayer structure. The photo-electric power generating element 10 includes an n-type crystal semiconductor substrate 11, an intrinsic amorphous silicon thin film 12, a p-type amorphous silicon thin film 13 and a first transparent conductive film 14 overlaid on one face side (upper side in FIG. 1) of the n-type crystal semiconductor substrate 11 in this order, and an n-type amorphous silicon thin film 15 and a second transparent conductive film 16 overlaid on another face side (lower side in FIG. 1) of the n-type crystal semiconductor substrate 11 in this order. Furthermore, the photo-electric power generating element 10 includes a collector electrode 17 provided on a surface (one face side) of the first transparent conductive film 14, and a collector electrode 18 provided on a surface (another face side) of the second transparent conductive film 16.

The n-type crystal semiconductor substrate 11 is not particularly limit as long as it is a crystal material having characteristics of n-type semiconductors, and a well-known n-type crystal semiconductor substrate may be used. As the n-type crystal semiconductor that constitutes the n-type crystal semiconductor substrate 11 is exemplified by silicon (Si), as well as SiC, SiGe, SiN and the like, and silicon is preferred in light of productivity, etc. The n-type crystal semiconductor substrate 11 may be either a monocrystal material, or a polycrystal material. The top and bottom (one face side and another face side) surfaces of the n-type crystal semiconductor substrate 11 preferably has protrusions and depressions through subjecting to a roughness treatment in order to achieve more effective light trapping by way of diffuse reflection of rays of light (not shown in the figure). It is to be noted that a large number of pyramidal protrusions and depressions can be formed through immersing the substrate material in an etching liquid containing, for example, about 1 to 5% by mass sodium hydroxide or potassium hydroxide.

The n-type crystal semiconductor substrate 11 is preferably produced by an epitaxy process. The epitaxy process is a method of forming an epitaxial layer by, for example, feeding a source gas on a crystal substrate. The formed epitaxial layer is separated from the crystal substrate, and can be suitably used as the n-type crystal semiconductor substrate 11. The n-type crystal semiconductor substrate 11 produced by an epitaxy process is advantageous in that: defects induced by oxygen are less likely to be generated; fewer impurities are involved; and a dopant can be contained at high reproducibility, as compared with substrates produced by a general Cz process or the like. Therefore, use of the n-type crystal semiconductor substrate 11 produced by an epitaxy process leads to an increase of the maximum output and the like of the photo-electric power generating element 10, and to an improvement of uniformity thereof. In other words, due to a small difference in resistivity between substrates, a large-scale production of the photo-electric power generating element 10 having desired output characteristics is facilitated. This effect is remarkably exhibited, in particular, when the side on which the collector electrode 18 is provided serves as the plane of light incidence (rear-emitter type). On the other hand, when the n-type crystal semiconductor substrate 11 is produced by a Cz process, since the substrate is obtained through cutting the silicon crystal to give a desired thickness, loss of the silicon in the cutting occurs. The loss of the silicon becomes more marked as the thickness of the substrate is smaller. However, in the case of the epitaxy process, the n-type crystal semiconductor substrate 11 can be directly produced to have a desired thickness, without need of cutting, and therefore, the loss of the silicon does not occur, leading to a cost reduction.

The resistivity of the n-type crystal semiconductor substrate 11 is preferably no less than 0.5 Ωcm and no greater than 5 Ωcm, and more preferably no less than 1 Ωcm and no greater than 3 Ωcm. When the n-type crystal semiconductor substrate 11 having the resistivity falling within the above range is used, maximum output and the like can be increased. When the resistivity is too small, the maximum output decreases resulting from a reduction of the bulk lifetime. When the resistivity is too great, the lateral resistance on the side where the n-type amorphous silicon thin film 15 is formed increases, whereby the fill factor is decreased. It is to be noted that control of the resistivity is facilitated by using the n-type crystal semiconductor substrate 11 produced by an epitaxy process.

The thickness (average thickness) of the n-type crystal semiconductor substrate 11 is preferably no less than 50 µm and no greater than 200 µm, and more preferably no less than 80 µm and no greater than 150 µm. When such a comparatively thin substrate is employed, an improvement of the output characteristics, and cost reduction can be both achieved while sufficient output characteristics are achieved.

The intrinsic amorphous silicon thin film 12 is overlaid on the one face side of the n-type crystal semiconductor substrate 11. In other words, the intrinsic amorphous silicon thin film 12 is interposed between the n-type crystal semiconductor substrate 11 and the p-type amorphous silicon thin film 13. The thickness of the intrinsic amorphous silicon thin film 12 is not particularly limited, and may be, for example, no less than 1 nm and no greater than 10 nm. When the film thickness is less than 1 nm, recombination of the carrier is likely to occur due to an increased tendency to generation of defects, and the like. In addition, when the film thickness is greater than 10 nm, a decrease of the short circuit current is likely to occur.

The p-type amorphous silicon thin film 13 is overlaid on the one face side of the intrinsic amorphous silicon thin film 12. The thickness of the p-type amorphous silicon thin film 13 is not particularly limited, and is, for example, no less than 1 nm and no greater than 20 nm, and more preferably no less than 3 nm and no greater than 10 nm.

The first transparent conductive film 14 is overlaid on the one face side of the p-type amorphous silicon thin film 13. Exemplary transparent electrode material that constitutes the first transparent conductive film 14 may include well-known materials such as e.g., indium tin oxide (ITO), tungsten-doped indium oxide (indium tungsten oxide: IWO), cerium-doped indium oxide (indium cerium oxide: ICO), IZO (indium zinc oxide), AZO (aluminum-doped ZnO), GZO (gallium-doped ZnO) and the like.

The n-type amorphous silicon thin film 15 is directly overlaid on the another face side of the n-type crystal semiconductor substrate 11. The thickness of the n-type amorphous silicon thin film 15 is not particularly limited, and is, for example, preferably no less than 1 nm and no greater than 20 nm, and more preferably no less than 4 nm and no greater than 10 nm. When the film thickness falls within such a range, a decrease of the short circuit current, and an occurrence of recombination of the carrier can be inhibited in a well-balanced manner.

The second transparent conductive film 16 is overlaid on the another face side of the n-type amorphous silicon thin film 15. The material for forming the second transparent conductive film 16 is similar to the material of the first transparent conductive film 14.

The collector electrodes 17, 18 include a plurality of busbar electrodes that are formed to be parallel with each other at regular intervals, and a plurality of finger electrodes formed to be orthogonal to these busbar electrodes and parallel with each other at regular intervals.

The busbar electrode and finger electrode are each linear or strip-shaped, and formed from an electrically conductive material. As this electrically conductive material, an electrically conductive adhesive such as a silver paste, and/or a metal lead wire such as a copper wire may be used. The width of each busbar electrode is, for example about no less than 0.5 mm and no greater than 2 mm, and the width of each finger electrode is, for example, about no less than 10 µm and no greater than 300 µm. In addition, the interval between the finger electrodes is, for example, about no less than 0.5 mm and no greater than 4 mm.

The photo-electric power generating element 10 having such a structure is typically used through connecting a plurality of the photo-electric power generating elements 10 in series. By using the plurality of photo-electric power generating elements 10 in series, generated voltage can be increased.

In the photo-electric power generating element 10, the side on which the n-type amorphous silicon thin film 15 is provided (corresponding to the side of the n-type amorphous silicon thin film 15 on which the transparent conductive film 16 is overlaid) is used as the plane of light incidence (arrowhead in FIG. 1 indicating the incident direction of light). By allowing the light to enter the pn-junction from the side where a layer of the intrinsic amorphous silicon thin film is absent, the efficiency of electric power generation can be enhanced. Additionally, in the photo-electric power generating element 10, since the intrinsic amorphous silicon thin film is not interposed between the n-type crystal semiconductor substrate 11 and the n-type amorphous silicon thin film 15, the manufacturing cost can be reduced.

### Method for Manufacturing Photo-Electric Power Generating Element

Next, a method for manufacturing the photo-electric power generating element 10 according to the second embodiment of the present invention will be explained.

The method for manufacturing the photo-electric power generating element 10 includes: (A) a step of overlaying the n-type amorphous silicon thin film 15 on the surface (inferior face) of the n-type crystal semiconductor substrate 11 by a chemical vapor deposition process; as well as (B) a step of overlaying the intrinsic amorphous silicon thin film 12 on the upper face of the n-type crystal semiconductor substrate 11; (C) a step of overlaying the p-type amorphous silicon thin film 13 on the upper face of the intrinsic amorphous silicon thin film 12; (D) a step of overlaying the transparent conductive films 14, 16 on the upper face of the p-type amorphous silicon thin film 13 and on the inferior face of the n-type amorphous silicon thin film 15, respectively; and (E) a step of providing collector electrodes 17, 18 on the upper face of the transparent conductive film 14 and the inferior face of the transparent conductive film 16, respectively. It is to be noted that the order of each step is not particularly limited as long as the layer structure of the photo-electric power generating element 10 can be obtained. Each step will be described in detail below.

### Step (A)

In the step (A) of directly overlaying the n-type amorphous silicon thin film 15 on the n-type crystal semiconductor substrate 11, for example, overlaying by a chemical vapor deposition process (for example, plasma CVD process, catalytic CVD process (may be also referred to as hot wire CVD process), etc.) is carried out in a state in which the temperature of the n-type crystal semiconductor substrate 11 is, for example, greater than 180 °C and no less than 220 °C, and more preferably no less than 190 °C and no greater than 210 °C. The chemical vapor deposition process carried out in a state in which the temperature of the n-type crystal semiconductor substrate 11 falls within the comparatively high range enables the n-type amorphous silicon thin film 15 accompanied by less generation of defects to be obtained while crystallization is inhibited, and thus a photo-electric power generating element 10 having a sufficient open circuit voltage and fill factor can be obtained. When the temperature is no greater than 180 °C, generation of defects is likely to occur, and may cause a decrease of the open circuit voltage and fill factor. To the contrary, when the temperature is greater than 220 °C, crystallization is likely to be caused in the formed thin film, which may lead to a decrease of the open circuit voltage and fill factor. As a source gas in forming the n-type amorphous silicon thin film 15, for example, a gas mixture of SiH₄, and PH₃ that is a kind of a dopant gas may be used.

The amount of PH₃ (dopant gas) introduced may be divided into portions for at least two steps through changing the flow rate. In other words, the n-type amorphous silicon thin film 15 may be overlaid by the chemical vapor deposition process of at least two steps in which a content of a dopant gas used in the source gas increases in sequence. Specifically, the process may be carried out through, for example, increasing the amount of PH₃ introduced (flow rate) stepwise, continuously increasing the amount of PH₃ introduced by way of varying gradient setting with a mass flow controller, or the like. Thus, an improvement of the passivation properties of the bonded interface between the n-type crystal semiconductor substrate 11 and the n-type amorphous silicon thin film 15 is enabled, and thus a photo-electric power generating element having a sufficient open circuit voltage and fill factor can be obtained.

For example, with respect to a content A of a dopant gas in the source gas directly overlaid on the n-type crystal semiconductor substrate 11 in the first step, a content B in the final step (for example, the second step when two steps are carried out) may be no less than 2 times and no greater than 50 times, and preferably no less than 5 times and no greater than 20 times. Further, a content A of a dopant gas in the source gas in the first step is about no less than 100 ppm and no greater than 2,000 ppm. The content B in the final step (for example, the second step when two steps are carried out) is about no less than 4, 000 ppm and no greater than 20,000 ppm.

By thus forming the n-type amorphous silicon thin film 15 through the chemical vapor deposition process including multiple steps (for example, two steps) in which the content of a dopant gas in the source gas increases in sequence, the n-type amorphous silicon thin film 15 will include a layer structure having varying electric resistance. Specifically, the n-type amorphous silicon thin film 15 will include at least a first layer that directly bonds to the n-type crystal semiconductor substrate 11, and a second layer that is overlaid on the another face side of the first layer and has an electric resistance less than that of the first layer.

### Step (B)

The overlaying of the intrinsic amorphous silicon thin film 12 may be carried out by a well-known method such as, for example, a chemical vapor deposition process (for example, a plasma CVD process, a catalytic CVD process (may be also referred to as hot wire CVD process), etc.). In the case where a plasma CVD process is carried out, for example, a gas mixture of SiH₄ and H₂ may be used as a source gas.

### Step (C)

The overlaying of the p-type amorphous silicon thin film 13 may be also carried out to form a film by a well-known method such as, for example, a chemical vapor deposition process (for example, a plasma CVD process, a catalytic CVD process (may be also referred to as hot wire CVD process), etc.). In the case where a plasma CVD process is carried out, for example, a gas mixture of SiH₄, H₂ and B₂H₆ may be used as a source gas.

### Step (D)

The overlaying of the transparent conductive films 14, 16 may be carried out by a well-known method such as, for example, a sputtering process, a vacuum deposition process and an ion plating process (reactive plasma vapor deposition process). It is to be noted that formation through, for example, an ion plating process which does not generate high-energy particles enables deterioration of the surface of the p-type amorphous silicon thin film 13 or the n-type amorphous silicon thin film 15 to be inhibited, and the adhesiveness between films to be increased.

### Step (E)

The collector electrodes 17, 18 may be provided by a well-known method. When an electrically conductive adhesive is used as a material for the collector electrodes 17, 18, the collector electrodes 17, 18 may be formed by a printing technique such as screen printing or gravure off-set lithography. Alternatively, when a metal lead wire is used for the collector electrodes 17, 18, these can be fixed on the transparent conductive films 14, 16 by means of an electrically conductive adhesive or a metal having a low melting point (solder, etc.).

The present invention is by no means limited to the aforementioned embodiments, and any modification can be made to the embodiments described above without departing from the spirit of the present invention. For example, the collector electrode on the one face side (the side opposite to the plane of light incidence) may not have the structure including the busbar electrode and the finger electrode, but may have a structure in which the electrically conductive material is overlaid on the entire face. The collector electrode having such a structure can be formed by e.g., overlaying a metal foil or plating. Still further, in place of the first transparent conductive film and the collector electrode on the one face side, an opaque conductive film formed by plating or a metal foil may be also used. When the one face side has such a structure, an efficiency of current collection on the one face side can be increased. In addition, since incident rays of light transmitted through the pn-junction among incident rays of light from the another face side, are reflected on the opaque conductive film or the collector electrode overlaid on the entire face, the efficiency of electric power generation can be enhanced.

### [EXAMPLES]

Hereinafter, the present invention will be more specifically explained by way of Examples and Comparative Examples. It should be noted that the present invention is not in any how limited to the following Examples.

### Example 1

On one face side of an n-type monocrystal silicon substrate (n-type crystal semiconductor substrate) produced by a Cz process, an intrinsic amorphous silicon thin film, a p-type amorphous silicon thin film and a first transparent conductive film were overlaid in this order. Next, an n-type amorphous silicon thin film and a second transparent conductive film were overlaid in this order on the another face side of the n-type monocrystal silicon substrate. Each transparent conductive film was overlaid by an ion plating process. When the n-type amorphous silicon thin film was formed, a lightly doped n-type amorphous silicon thin film (first layer) having a thickness of 3 nm was first formed with an amount of PH₃ introduced of 800 ppm (in terms of the contend of PH₃ with respect to the total source gas), and then a highly doped n-type amorphous silicon thin film (second layer) was overlaid on the lightly doped n-type amorphous silicon thin film, with an amount of PH₃ introduced of 8,000 ppm in the same film forming room in sequence.

Intrinsic amorphous silicon thin film on the one face side
substrate temperature: 200 °C; film thickness: 4 nm
source gas: SiH₄

Highly doped p-type amorphous silicon thin film
substrate temperature: 200 °C; film thickness: 6 nm
source gas: SiH₄ and B₂H₆
amount of B₂H₆ introduced: 8,000 ppm

Lightly doped n-type amorphous silicon thin film
substrate temperature: 200 °C; film thickness: 3 nm
source gas: SiH₄ and PH₃
amount of PH₃ introduced: 800 ppm

Highly doped n-type amorphous silicon thin film
substrate temperature: 200 °C; film thickness: 3 nm
source gas: SiH₄ and PH₃
amount of PH₃ introduced: 8,000 ppm

Then, on the surfaces (external surfaces) of the first and second transparent conductive films, a plurality of parallel busbar electrodes, and a plurality of finger electrodes each orthogonal to these busbar electrodes were formed as the collector electrodes, respectively. The collector electrodes were formed by screen printing using a silver paste. Accordingly, a photo-electric power generating element of Example 1 was obtained.

### Comparative Examples 1 to 9

On one face side of an n-type monocrystal silicon substrate, an intrinsic amorphous silicon thin film, a p-type amorphous silicon thin film and a first transparent conductive film were overlaid in this order. Next, an intrinsic amorphous silicon thin film, an n-type amorphous silicon thin film and a second transparent conductive film were overlaid in this order on the another face side of the n-type monocrystal silicon substrate. Each transparent conductive film was overlaid by an ion plating process. When the n-type amorphous silicon thin film was formed, the lightly doped n-type amorphous silicon thin film of Example 1 was not overlaid, and a highly doped n-type amorphous silicon thin film was overlaid on the intrinsic amorphous silicon thin film with an amount of PH₃ introduced of 8,000 ppm.

Intrinsic amorphous silicon thin film on the one face side
substrate temperature: 200 °C; film thickness: 6 nm
source gas: SiH₄

Highly doped p-type amorphous silicon thin film
substrate temperature: 200 °C; film thickness: 4 nm
source gas: SiH₄ and B₂H₆
amount of B₂H₆ introduced: 8,000 ppm.

Intrinsic amorphous silicon thin film on the another face side
substrate temperature: 200 °C; film thickness: X nm
source gas: SiH₄

Highly doped n-type amorphous silicon thin film
substrate temperature: 200 °C; film thickness: Y nm
source gas: SiH₄ and PH₃
amount of PH₃ introduced: 8,000 ppm

The film thickness (X nm) of the intrinsic amorphous silicon thin film on the another face side, and the film thickness (Y nm) of the highly doped n-type amorphous silicon thin film were as in the following.
Comparative Example 1: X = 2 nm, Y = 2 nm
Comparative Example 2: X = 2 nm, Y = 4 nm
Comparative Example 3: X = 2 nm, Y = 6 nm
Comparative Example 4: X = 4 nm, Y = 2 nm
Comparative Example 5: X = 4 nm, Y = 4 nm
Comparative Example 6: X = 4 nm, Y = 6 nm
Comparative Example 7: X = 6 nm, Y = 2 nm
Comparative Example 8: X = 6 nm, Y = 4 nm
Comparative Example 9: X = 6 nm, Y = 6 nm

The short circuit current (Isc), the open circuit voltage (Voc), the fill factor (FF) and the maximum output (Pmax) of each photo-electric power generating element obtained were measured. It is to be noted that the side on which the n-type amorphous silicon thin film is provided was employed as a main plane of light incidence. The measurement results are shown in Table 1.

**Table 1**

| | Short circuit current Isc (A) | Open circuit voltage Voc (V) | Maximum output Pmax (W) | Fill factor FF |
|---|---|---|---|---|
| Example 1 | 9.060 | 0.733 | 5.41 | 0.822 |
| Comparative Example 1 | 5.683 | 0.608 | 2.77 | 0.800 |
| Comparative Example 2 | 8.948 | 0.726 | 5.21 | 0.803 |
| Comparative Example 3 | 8.919 | 0.729 | 5.25 | 0.808 |
| Comparative Example 4 | 8.559 | 0.664 | 4.46 | 0.785 |
| Comparative Example 5 | 8.894 | 0.729 | 5.23 | 0.807 |
| Comparative Example 6 | 8.964 | 0.731 | 5.29 | 0.807 |
| Comparative Example 7 | 8.869 | 0.691 | 4.67 | 0.762 |
| Comparative Example 8 | 8.965 | 0.730 | 5.27 | 0.806 |
| Comparative Example 9 | 8.883 | 0.730 | 5.26 | 0.811 |

As shown in Table 1, it was revealed that the photo-electric power generating element of Example 1 exhibited improved fill factor as compared with the photo-electric power generating elements of Comparative Examples 1 to 9 in which the intrinsic amorphous silicon thin film was interposed between the n-type monocrystal silicon substrate and the n-type amorphous silicon thin film. In addition, it was revealed that the short circuit current and the open circuit voltage were also improved.

Operational advantages of this Example will be explained in detail below. The transparent conductive film can be regarded as a degenerate semiconductor. In other words, owing to the presence of carriers (free electrons present in a conduction band, or free holes present in a valence band) at a high concentration, the Fermi level would exist in the conduction band or the valence band, leading to physical properties exhibited similar to those of metals, whereby the bonding between the transparent conductive film and the n-type amorphous silicon thin film can be regarded as if it were a metal-semiconductor junction. The metal-semiconductor junction between the transparent conductive film and the n-type amorphous silicon thin film causes band bending in the n-type amorphous silicon thin film. Thus, as the film thickness (X + Y) that is a total of the thicknesses of the intrinsic amorphous silicon thin film and the n-type amorphous silicon thin film becomes smaller, overlapping of space charge layers at heterojunction portions between the n-type monocrystal silicon substrate and the n-type amorphous silicon thin film, and at metal-semiconductor junction portions between the transparent conductive film and the n-type amorphous silicon thin film begins, whereby a reduction of minority carrier lifetime is caused. The reduction of the minority carrier lifetime causes a reduction of the open circuit voltage (Voc). In addition, when the another face side is employed as a plane of light incidence, provided that recombination of minority carriers increases on the side of the front surface field in which the n-type amorphous silicon thin film is formed, efficient recovery through separation of the carriers is prevented, and also the short circuit current (Isc) decreases. Moreover, the results shown in Table 1 suggests that the open circuit voltage (Voc) is prevented from the lowering, in a case where a thick n-type amorphous silicon thin film that is a doped layer is provided than in a case where a thick intrinsic amorphous silicon thin film that is an undoped layer is provided. On the other hand, when the side on which the n-type amorphous silicon thin film is formed is employed as a plane of light incidence, the short circuit current can be increased as the thickness of the film of the n-type amorphous silicon thin film layer is smaller to some extent.

In Example 1, a lightly doped n-type amorphous silicon thin film is overlaid in place of an intrinsic amorphous silicon thin film, and thus the total thickness of the amorphous silicon thin film layer on the side of the front surface field can be minimized within the range in which overlapping of the space charge layers does not affect, whereby both a high short circuit current and a high open circuit voltage can be attained. Moreover, a lightly doped n-type amorphous silicon thin film having a low resistance was overlaid in place of the intrinsic amorphous silicon thin film having a high resistance, and thus the fill factor was increased.

### Example 2

A photo-electric power generating element of Example 2 was obtained in a similar manner to Example 1 except that an n-type monocrystal silicon substrate (thickness 150 µm) produced by an epitaxy process was used, and a thermal donor killer annealing step was omitted. The thermal donor killer annealing step as referred to means a procedure of removing a thermal donor in the n-type monocrystal silicon substrate, and is particularly important in heterojunction elements produced according to a low-temperature process. In other Examples and Comparative Examples in which the n-type monocrystal silicon substrate produced by a Cz process was used, the thermal donor killer annealing step was carried out. By omitting this step, a reduction of the manufacturing cost can be enhanced. The photo-electric power generating element of Example 2 obtained had a short circuit current (Isc) of 9.050 A, an open circuit voltage (Voc) of 0.735 V, a maximum output (Pmax) of 5.45 W, and a fill factor (FF) of 0.820.

### Example 3

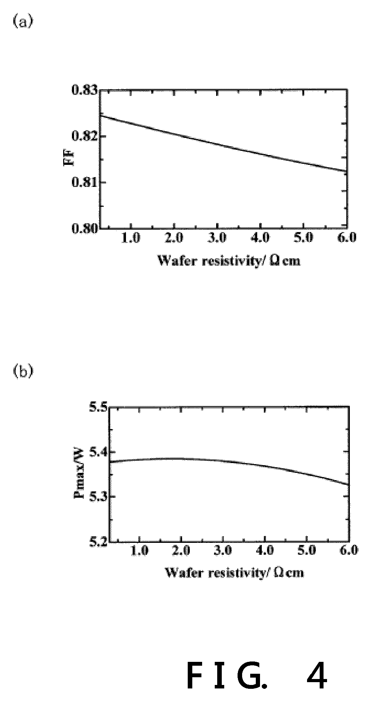

A photo-electric power generating element was obtained by a similar method to Example 1 using an n-type monocrystal silicon having a resistivity of 0.3 to 6 Ωcm (Cz process). Measurement results of FF (fill factor) and Pmax (maximum output) of each photo-electric power generating element thus obtained are shown in FIGs. 4 (a) and (b). As shown in FIG. 4 (a), along with an increase of the resistivity, the effective lateral resistance on the side on which the n-layer amorphous silicon thin film is formed increases, and FF (fill factor) decreases. As shown in FIG. 4 (b), since an advantage of an improvement of FF along with a decrease of the resistivity competes with a disadvantage of a reduction of the bulk lifetime, the resistivity preferably falls within the range of 0.5 to 5 Ωcm, and particularly preferably falls within the range of 1 to 3 Ωcm. Since epitaxial substrates are accompanied by extremely few oxygen defects, and the resistivity can be controlled only with the doping level, it is possible to adjust the resistivity so as to accurately fall within the preferred range.

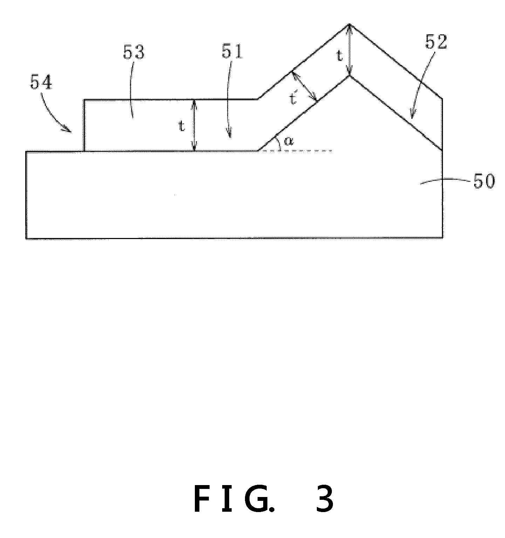

In this paragraph, the film thickness of each amorphous silicon thin film in Examples is explained. A virtual substrate 50 having both a smooth part 51 and a part having protrusions and depressions 52 is shown in FIG. 3. By using, for example, a transmission electron microscope (TEM), a thickness t perpendicular to the substrate 50, a thickness t' perpendicular to the plane, and an angle α in the part having protrusions and depressions 52 can be each measured. As referred to herein, the film thickness of an amorphous silicon thin film 53 overlaid on the smooth part 51 designates "t", whereas the film thickness of the amorphous silicon thin film 53 overlaid on the part having protrusions and depressions 52 designates "t'". In factual operations, a film thickness-evaluating method is preferably adopted which enables shortening of a measurement time period, and which uses a convenient surface profilometer or the like. The difference in level 54 is formed by, for example, wet-etching the amorphous silicon thin film 53 with a liquid prepared by heating KOH or NaOH to 40 to 50 °C, and "t" is measured according to the film thickness-evaluating method using the surface profilometer. Since an equality of t' = t * cosα is satisfied based on a trigonometrical function, calculation of t' would be possible from "t" thus measured. Since it was confirmed that t' obtained by the TEM measurement agrees with t' calculated according to the film thickness evaluation method using the surface profilometer, the film thickness-evaluating method using the surface profilometer was employed in the Examples. It is to be noted that the surface profilometer is an instrument for conducting a measurement through moving a probe upward and downward depending on the difference in level on a sample by horizontally tracing the surface with the probe to be contact with the sample, on the sample on which the difference in level was provided beforehand.

### [Explanation of the Reference Symbols]

- 10:: photo-electric power generating element
- 11:: n-type crystal semiconductor substrate
- 12:: intrinsic amorphous silicon thin film
- 13:: p-type amorphous silicon thin film
- 14:: first transparent conductive film
- 15:: n-type amorphous silicon thin film
- 16:: second transparent conductive film
- 17,: 18: collector electrode
- 50:: substrate
- 51:: smooth part
- 52:: part having protrusions and depressions
- 53:: amorphous silicon thin film
- 54:: difference in level

## Claims

1. A photo-electric power generating element comprising: an n-type crystal semiconductor substrate; a p-type amorphous silicon thin film overlaid on one face side of the n-type crystal semiconductor substrate; and an n-type amorphous silicon thin film overlaid on another face side of the n-type crystal semiconductor substrate,
wherein
the photo-electric power generating element further comprises an intrinsic amorphous silicon thin film interposed between the n-type crystal semiconductor substrate and the p-type amorphous silicon thin film,
the n-type crystal semiconductor substrate and the n-type amorphous silicon thin film are directly bonded, and
a side on which the n-type amorphous silicon thin film is provided is used as a plane of light incidence.

2. The photo-electric power generating element according to claim 1, wherein the n-type amorphous silicon thin film is overlaid by a chemical vapor deposition process comprising at least two steps in which a content of a dopant gas in a source gas increases in sequence.

3. The photo-electric power generating element according to claim 1 or 2, wherein the n-type amorphous silicon thin film comprises a first layer that directly bonds to the n-type crystal semiconductor substrate, and a second layer that is overlaid on a side of the first layer opposite to the n-type crystal semiconductor substrate and has an electric resistance less than the electric resistance of the first layer.

4. The photo-electric power generating element according to any one of claims 1 to 3, wherein the n-type amorphous silicon thin film is overlaid by a chemical vapor deposition process, and overlaying by the chemical vapor deposition process is carried out in a state in which a temperature of the n-type crystal semiconductor substrate is greater than 180 °C and no less than 220 °C.

5. The photo-electric power generating element according to any one of claims 1 to 4, wherein the n-type crystal semiconductor substrate is produced by an epitaxy process.

6. The photo-electric power generating element according to any one of claims 1 to 5, wherein a resistivity of the n-type crystal semiconductor substrate is no less than 0.5 Ωcm and no greater than 5 Ωcm.

7. The photo-electric power generating element according to any one of claims 1 to 6, wherein the n-type crystal semiconductor substrate has a thickness of no less than 50 µm and no greater than 200 µm.

8. The photo-electric power generating element according to claim 7, wherein the n-type crystal semiconductor substrate has a thickness of no less than 80 µm and no greater than 150 µm.

9. A method for manufacturing a photo-electric power generating element comprising overlaying an n-type amorphous silicon thin film on a surface of an n-type crystal semiconductor substrate by a chemical vapor deposition process, wherein
the overlaying by the chemical vapor deposition process is carried out in a state in which a temperature of the n-type crystal semiconductor substrate is greater than 180 °C and no less than 220 °C.
